# EUROPEAN PATENT APPLICATION

(11) **EP 3 333 910 A1**
(43) Date of publication of application: **13.06.2018**
(21) Application number: 17204998.3
(22) Date of filing: 01.12.2017
(51) Int. Cl.: H01L 33/48, H05K 3/00, B29C 65/54, B29C 65/50

(54) **IMPROVED LED MODULE BONDING**

(30) Priority: 07.12.2016 US 201662431370 P; 04.10.2017 US 201715724896
(71) Applicant: GE Lighting Solutions, LLC, Cleveland, OH 44112 (US)
(72) Inventor: FENG, Yongli, Xian, Shaanxi 710065 (CN); CHEN, Yong fen, Xian, Shaanxi 710065 (CN); SPAHNIE, Brian Morgan, East Cleveland, OH Ohio 44112 (US); NI, Yan, ShangHai, Shanghai 201203 (CN)
(74) Representative: Foster, Christopher Michael

(57) **Abstract**

An LED module (200, 300, 310, 320, 402, 404) having improved bonding features is described. In some embodiments, an LED module (200, 300, 310, 320, 402, 404) includes at least one LED light source (202A, 202B, 202C, 202D), at least one wire (208A, 208B, 208C, 208D), and a housing (204) that has a rear wall having a surface (302). A flow channel (214A, 214B, 306A, 306B, 308A, 308B, 312A, 312B) is cut into at least one portion of the surface (302) of the rear wall, which provides additional surface area when glue is applied to affix the housing (204) of the LED module (200, 300, 310, 320, 402, 404) to a substrate.

## Description

### FIELD OF THE INVENTION

The present disclosure generally relates to methods and apparatus for improving the bonding force of an LED module which is to be mounted to a substrate. More particularly, the method includes cutting or etching glue flow channels into a backside or rear portion of the housing of an LED module to improve the bonding force of glue introduced into the flow channels when attaching the LED module to the substrate.

### BACKGROUND

The Light Emitting Diode (LED) is an excellent source of light, and provides advantages including convenience and low power consumption. LED-based lighting components and/or LED fixtures are thus being widely utilized for many indoor and outdoor lighting applications. For example, LED lighting is currently being used for applications such as indoor light fixtures, outdoor street lights, traffic lights, large screen displays and/or electronic billboards, and the like. In some embodiments, LED lights are manufactured as LED modules which include one or more LEDs mounted to a printed circuit board (PCB board), which may be rectangular shaped, and which may be controlled by hardware components and/or software. Such LED modules typically are from one inch (1") to seven inches (7") long and one-half inch (½") to one and one-half inches (1 ½") wide, and may have a thickness of from one-half inch (½") to one inch (1"). Such LED modules are highly versatile, and can be used in light boxes, for cove lighting, to illuminate signs, to form letters of signs, and for a host of other applications. Because they are connected by wires instead of being mounted on a rigid substrate, LED modules can be positioned in many ways.

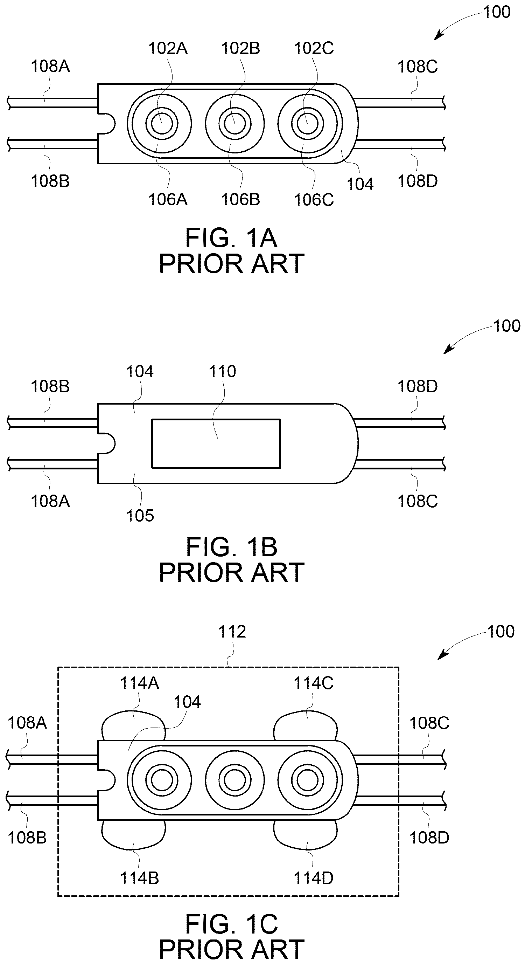

FIGS. 1A and 1B are top and bottom views, respectively, of a conventional LED module 100 that includes three LED light sources 102A, 102B, 102C. The LED light sources 102A, 102B, 102C are typically mounted on a printed circuit board (PCB; not shown) and then housed within a housing 104. The housing 104 of the LED module may be made of plastic, rubber or of other lightweight composite materials. The LED module 100 may also include driver circuitry and/or a controller (not shown), and may be configured or designed to protect the LED light sources 102A, 102B, 102C and interior electronic components from the ambient environment. As shown in FIG. 1A, each LED light source 102A, 102B, 102C has an associated lens 106A, 106B, 106C, and wires 108A, 108B, 108C, 108D protruding from the housing 104 for connecting the LED module 100 to a power source and/or to other LED modules. As shown in FIG. 1B, the rear wall or back side 105 of the housing 104 includes a double-sided mounting tape 110 which is typically utilized to position and affix the LED module 100 to a substrate (not shown), which substrate may be part of a larger light fixture, such as a residential light fixture and the like.

FIG. 1C is a top view of the LED module 100 of FIGS. 1A and 1B illustrating connection to a substrate 112. As shown in FIG. 1C, the rear side 105 of the housing 104 is affixed to the substrate 112 via the tape 110 (shown in FIG. 1B). The substrate 112 is shown as a dotted line environment because the substrate 112 may be of many different sizes. In addition, the substrate 112 may be composed of many different types of materials, such as plastic, rubber, metal, or a composite material. Referring again to FIG. 1C, after attaching the LED module 100 to the substrate 112 via the double-sided mounting tape, it is common to apply dollops or beads of glue 114A, 114B, 114C and 114D in areas that are adjacent to several edge locations of the housing 104, wherein a portion of each dollop or bead of glue may affix a portion the rear wall 105 to a portion of the substrate 112. Thus, in this example, a fabricator used beads of glue 114A, 114B, 114C and 114D in addition to the double-sided tape 110 to attach the housing 104 to the substrate 112. In particular, the beads of glue 114A, 114B, 114C and 114D typically only adhere only to a very small area of the side wall portions of the LED module 100, without contacting the top wall portion (which includes the LEDs). Use of such a conventional adhesion process to affix or mount an LED module to a substrate (for example, within a signage box) exposes the LED module to detachment from the substrate when normal handling, movement or transport occurs.

Other methods for attaching an LED module 100 to a substrate 112 are known, such as utilizing only single or double-sided tape, but this can be disadvantageous because it allows for the easy inadvertent detachment of the LED module from a substrate during normal and/or rough handling (such as transport and/or inadvertent dropping of a light fixture). In addition, a fabricator could use glue only to affix the LED module to the substrate, but this can be time consuming as the fabricator would have to wait until the glue cures before the substrate and LED module can be moved or else the LED module may easily detach from the substrate (for example, during shipping). The fabricator could also use single or double-sided tape in combination with a screw or other mechanical fastener, especially in situations where the substrate is made of a metallic material. However, use of a mechanical fastener, such as a screw, adds costs in terms of labor, materials, and speed of fabrication which increases the overall cost of the LED light fixture, which in some implementations can include many LED modules.

Therefore, it would be advantageous to provide a method for improving the bonding force between an LED module and a substrate that is low cost, and that facilitates secure attachment of the LED module to the substrate.

### BRIEF SUMMARY OF THE INVENTION

Improved bonding features for an LED module are disclosed. In some embodiments, the LED module includes at least one LED light source, at least one wire, and a housing. The housing has a rear wall having a surface, and a method includes cutting at least one flow channel into at least one portion of the surface of the rear wall to accommodate glue used to affix the LED module to a substrate. In some embodiments, the method may also include, before cutting one or more flow channels, affixing mounting tape to the surface of the rear wall. In addition, in some embodiments at least one flow channel pattern may be selected which is then used to cut the flow channel(s) into the rear wall of the LED module, adjacent to the mounting tape.

### BRIEF DESCRIPTION OF THE DRAWINGS

Features and advantages of some embodiments, and the manner in which the same are accomplished, will become more readily apparent with reference to the following detailed description taken in conjunction with the accompanying drawings, which illustrate exemplary embodiments (not necessarily drawn to scale), wherein:
FIGS. 1A and 1B are top and bottom views, respectively, of a conventional LED module;
FIG. 1C is a top view of the LED module of FIGS. 1A and 1B illustrating attachment to a substrate;
FIGS. 2A and 2B illustrate top and rear side views of an LED module that includes a mounting tape and flow channels on either side of the mounting tape, in accordance with some embodiments of the disclosure;
FIGS. 3A, 3B and 3C are rear wall views of three LED modules having flow channels, wherein each LED module includes a different flow channel pattern in accordance with some embodiments of the disclosure; and
FIG. 4 is a table including pull force test results of sample LED modules that do not include flow channels as compared to LED modules that do include flow channels in accordance with some embodiments of the disclosure.

### DETAILED DESCRIPTION

Reference now will be made in detail to illustrative embodiments, one or more examples of which are illustrated in the drawings. Like components and/or items in the various drawings are identified by the same reference number, and each example is provided by way of explanation only and thus does not limit the invention. In fact, it will be apparent to those skilled in the art that various modifications and/or variations can be made without departing from the scope and/or spirit of the invention. For instance, in many cases features illustrated or described as part of one embodiment can be used with another embodiment to yield a further embodiment. Thus, it is intended that the present disclosure covers such modifications and variations as come within the scope of the appended claims and their equivalents.

In general, and for the purpose of introducing concepts of embodiments of the present invention, methods and apparatus are described for enhancing the bonding force of glue utilized to connect a light emitting diode (LED) module to a substrate. Embodiments described herein advantageously do not use any complex parts. Instead, flow channels or grooves are added or cut into the back side or rear side of the LED module before it is glued to the substrate. It should be noted that the LED module typically includes a housing that accommodates one or more LED chips (light sources), and thus may include multiple light emitting diodes (LEDs) mounted to a circuit board (such as a PCB). Each LED module also includes wires for interconnecting several LED modules together (to form a string of LED light sources) and/or to a power source. In addition, some LED module embodiments also include a driver component and/or a controller component and/or other electronic components. The housing may also be designed and/or configured in such manner to protect or shelter the LED(s) and the electronic components from the ambient environment (for example, the LED module may be water resistant or waterproof). In accordance with methods described herein, flow channels or grooves are scored or otherwise cut into a portion of the rear side or back side wall of an LED module, wherein such flow channels can take the form of many different types of suitable patterns. The flow channels facilitate the spreading or flowing of glue or other adhesive that is added during assembly of, for example, a light fixture utilizing the LED module (which is affixed to a substrate). Thus, the flow channels enable glue to easily flow underneath the LED module when connecting it to the substrate, and (as explained further below) the flow channels increase the bonding strength of the glue used to affix the LED module to the substrate as compared to conventional methods.

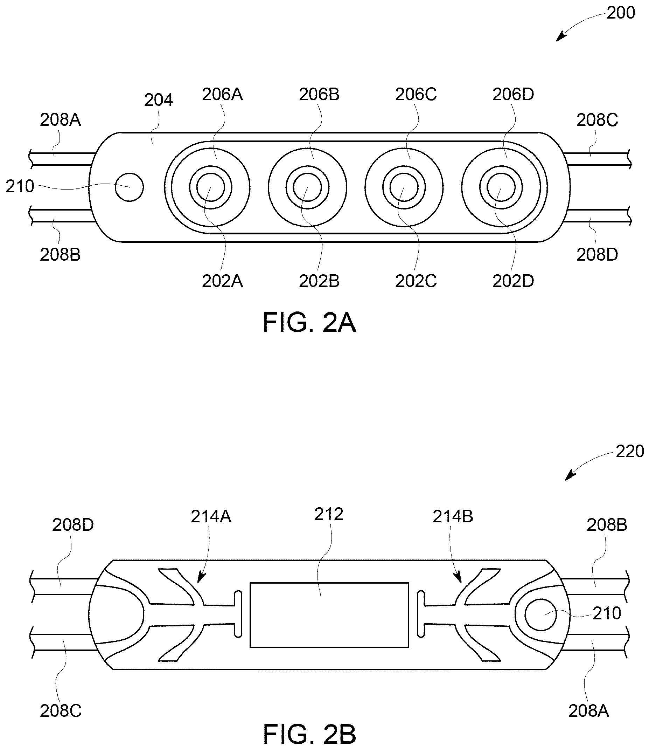

FIG. 2A is a top view of an LED module 200 that includes four LED light sources 202A, 202B, 202C and 202D. The LED light sources are typically mounted to a printed circuit board (PCB; not shown), and then seated or installed within a housing 204. Each LED light source 202A, 202B, 202C and 202D has an associated lens elements 206A, 206B, 206C and 206D, and wires 208A, 208B, 208C and 208D that protrude from the housing 204 for connecting the LED module 200 to a power source and/or to other LED modules (not shown). A mounting hole 210 may also be provided, which may accommodate a mechanical fastener, such as a screw. The LED module 200 may also include a driver and/or a controller (not shown), and the housing 204 and lenses 206A, 206B, 206C and 206D may be configured and/or composed of materials that protect the LED light sources 202A, 202B, 202C and 202D, and other electronic components, from the ambient environment. For example, in some embodiments the LED module 200 may be water resistant or water proof so that it can be used outdoors.

FIG. 2B is a rear or back side view 220 of the LED module 200 of FIG. 2A illustrating use of a mounting tape 212, which may be double-sided, and to illustrate the grooves or flow channels 214A and 214B which have been carved or cut into the rear side wall on opposite sides of the mounting tape 212. The mounting tape may include an adhesive that permits attachment and then easy removal of the LED module 200 so as to facilitate positioning or placement of the LED module 200 on a substrate before applying any glue. Thus, in novel embodiments described herein, an LED module 200 includes flow channels or grooves that have been cut, carved, etched, incised or otherwise inscribed onto at least a portion of the surface of the rear wall of the LED module, in an area or areas apart from the location of a mounting tape. Such flow channels facilitate the flow or spreading of glue (or other glue-like adhesive) between the rear wall of the LED module and a substrate during attachment of the LED module to the substrate, for example, during assembly of an LED light fixture.

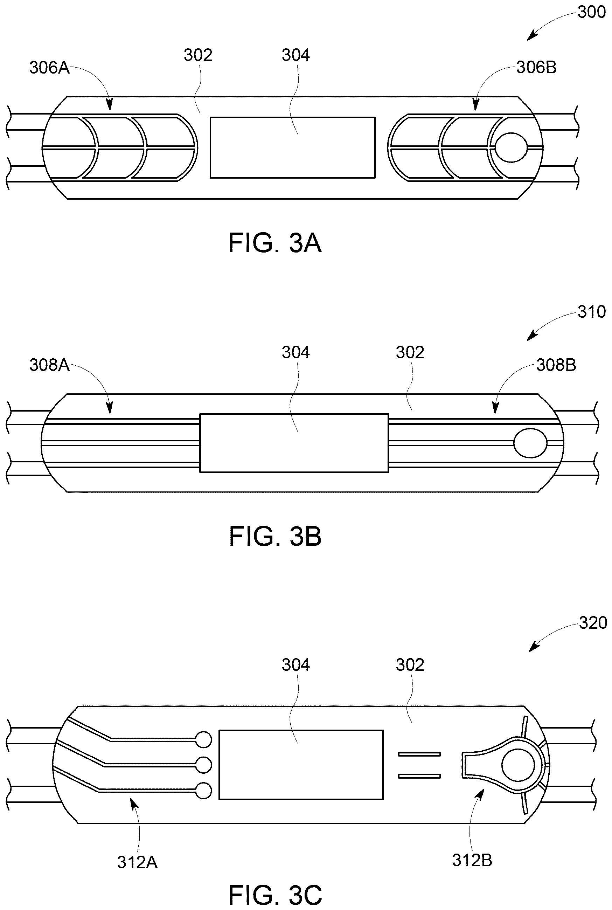

FIGS. 3A, 3B and 3C illustrate three different patterns of flow channels cut into the rear side wall 302 of an LED module in accordance with the disclosure. In particular, the LED module 300 of FIG. 3A includes a rear wall surface 302 that includes a mounting tape 304 and a first pattern of flow channels 306A and a second pattern of flow channels 306B on either side of the mounting tape 304. In the example shown in FIG. 3A, the first and second patterns of flow channels are mirror images of each other (or are symmetric), but other embodiments could include flow channel patterns that are asymmetric. The LED module 310 of FIG. 3B also includes a rear wall surface 302 that includes a mounting tape 304 and a first pattern of grooves 308A and a second pattern of grooves 308B cut into the rear wall on either side of the mounting tape 304. In the example shown in FIG. 3B, the flow channels 308A and 308B are straight lines, and are mirror images of each other. In contrast, FIG. 3C illustrates an LED module 320 having a rear wall surface 302 that includes a mounting tape 304 and a first pattern of flow channels 312A and a different, second pattern of flow channels 312B cut into the rear wall on either side of the mounting tape 304. As shown, the first pattern of flow channels 312A is completely different from the second pattern of flow channels 312B. Thus, the shape of the flow channels or grooves incised into the back side or rear side of an LED module, and their relationship to each other, is not important. What is important is that the flow channels cut into the rear wall of the LED module enhance glue fluidity so that the glue spreads beneath the LED module (underneath the rear wall) when the LED module is being affixed to a substrate with glue (for example, during installation of the LED module into a sign box or the like). In addition, the flow channels may increase the glue volume and/or glue area (fixation zone), as well as improve the interface between the glue and the rear wall surface of the LED module. Accordingly, the flow channels may have at least two functions: first, to allow glue to flow during attachment of the LED module to the substrate (i.e., to flow "like a river" into the flow channel); and second, to provide a greater surface area for the glue, which improves the contact area between the rear wall of the LED module and a substrate, resulting in a generally increased bonding force.

Thus, the flow channels or flow grooves may have any number of different shapes, and may be included to cover a portion or all of the surface area of the back side wall or rear wall area of an LED module. In addition, the flow channels can be etched into the back wall of the LED module to any suitable depth. In practice, for a typical LED module that includes three to four LED light sources, the depth of a flow channel cut into the back or rear wall of the LED module may be from about 0.1 millimeter (mm) to about 1.0 mm. One factor to consider when selecting the channel depth is that care must be taken when cutting into the LED module rear wall to avoid damaging internal components, such as the printed circuit board (PCB) and/or driver circuitry and/or other electronic components and/or the LED light source components themselves. In addition, the flow channel cut into the rear wall of an LED module may not have a uniform depth, but may include portions that are more or less deep than other portions (which again may be dependent on the location of internal electronic components and the like found within the housing of the LED module).

Tests were conducted to confirm that the flow channels improve and/or increase the bonding force of LED modules to substrates as compared to LED modules with a smooth rear wall. Thus, select types of LED modules including flow channels cut into a back wall were glued to a substrate in the manner described herein and then were compared to conventional LED modules with a smooth rear wall glued to the same substrate. LED modules that include or house three LEDs and/or four LEDs were used during the testing, as was a mounting tape sold by the 3M Company, HT933 flow type silicon glue, and a bakelite substrate. The HT933 silicon glue features high strength and excellent adhesion properties (it can adhere to aluminum, copper, stainless steel and other metals). Each of the tested LED modules was approximately three inches (3") long, about one-half inch (0.5") wide, and about one-half inch (0.5") thick. In order to provide result comparisons, a first set of LED modules did not include any flow channels (i.e., the back wall was smooth), a second set of LED modules included flow channels having a depth of 0.4mm, and a third set of LED modules included flow channels that were 0.7mm in depth. After each type of LED module was glued to the substrate and the glue allowed to cure (to provide maximum bonding strength), a strain gauge was next utilized to measure the pull force needed to pull apart each type of LED module from the substrate, and the pulling force required to do so was recorded.

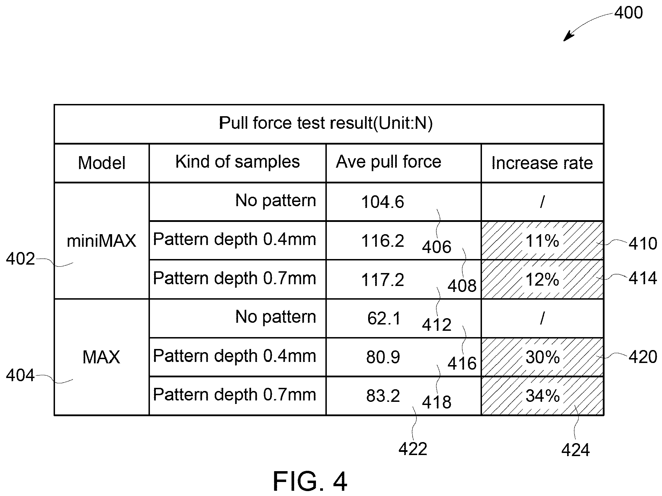

Accordingly, FIG. 4 is a table 400 of pull force test results, which includes entries indicating the pulling force necessary to detach a selected type of LED module from a substrate in Newtons (wherein 1 newton (N) is equal to 1-kilogram meter per second squared, or can be thought of as the force required to accelerate an object with a mass of 1 kilogram to 1 meter per second per second). In particular, a "miniMAX" LED module 402 and a "MAX" LED module 404 manufactured by the General Electric company, were used in the tests. (It should be understood that other types of LED modules manufactured by other companies could have been utilized as well, and the descriptions provided herein of the pulling force test results are not meant to be limiting in any manner.) The minimax LED module 402 has dimensions of about two inches (2.0") in length, seven-tenths of an inch (0.7") in width, and six-tenths of an inch (0.6") in depth. The MAX LED module 404 has dimensions of about three inches (3.0") in length, seven-tenths of an inch (0.7") in width, and six-tenths of an inch (0.6") in depth. The miniMAX LED modules and the MAX LED modules were first affixed to a bakelite substrate using mounting tape, and then the HT933 flow type silicon glue was used to bond the LED modules to the substrate. Each of the LED modules that included flow channels had flow channel patterns 214A and 214B as shown in FIG. 2B.

Referring to the table 400 of FIG. 4, an average pull force 406 of 104.6 N was needed to detach three miniMAX LED modules 402 without any flow channels from the bakelite substrate. However, when the same test was conducting using three miniMAX LED modules with flow channel patterns 214A and 214B cut into the rear wall with a pattern depth of 0.4 mm (such that glue flowed into the flow channels when being connected to the substrate), it took an average pull force 408 of 116.2 N to detach the miniMAX LED modules from the substrate, which is an eleven percent (11%) increase 410 as compared to LED modules without flow channels. Moreover, when the miniMAX LED modules included flow channels 214A and 214B having a pattern depth of 0.7 mm were glued to the substrate (such that glue flowed into the flow channels when being connected to the substrate) it took an average pull force 412 of 117.2 N to detach the LED module from the substrate, which is a twelve percent (12%) increase 414 from that of LED modules that did not include flow channels.

Referring again to FIG. 4, in the case of the MAX LED modules 404, when three MAX LED modules without any flow channels were glued to the substrate it took an average pull force 416 of 62.1 N to detach them from the substrate. However, when the MAX LED modules included flow channel patterns 214A and 214B cut into the rear wall with a pattern depth of 0.4 mm, (such that glue flowed into the flow channels when being connected to the substrate) it took an average pull force 418 of 80.9 N to detach those LED modules from the substrate, which is a thirty percent (30%) increase in pull force 420 as compared to modules lacking flow channels. Moreover, when three MAX LED modules included flow channels 214A and 214B having a pattern depth of 0.7 mm (such that glue flowed into the flow channels when being connected to the substrate), it took an average pull force 422 of 83.2 N to detach those LED module from the substrate, which is a thirty-four percent (34%) increase 424 as compared to the same type of LED module without flow channels.

Accordingly, as illustrated by the table 400 of FIG. 4, when flow channels are cut into the rear wall of an LED module having pattern depths of 0.4 mm and 0.7 mm the pulling force required to detach the LED module from the substrate increases as compared to LED modules which do not include any flow channels. In particular, specific exemplary embodiments described herein increased the bonding of LED modules to substrates from about 15% to about 30%. The test results therefore indicate that use of flow channels or grooves cut into the rear wall of an LED module increases the adhesive bonding of those LED modules to substrates.

The above descriptions and/or the accompanying drawings are not meant to imply a fixed order or sequence of steps for any process or method of manufacture referred to herein. Thus, any disclosed process may be performed in any order that is practicable, including but not limited to simultaneous performance of one or more steps that are indicated as sequential.

Although the present invention has been described in connection with specific exemplary embodiments, various changes, substitutions, modifications and/or alterations apparent to those skilled in the art can be made to the disclosed voice activated lighting apparatus and/or voice activated lamp system embodiments without departing from the spirit and scope of the invention as set forth in the appended claims.

## Claims

1. A method for providing an LED module (200, 300, 310, 320, 402, 404) with improved bonding features comprising:
obtaining an LED module (200, 300, 310, 320, 402, 404) comprising at least one LED light source (202A, 202B, 202C, 202D), at least one wire (208A, 208B, 208C, 208D), and a housing (204), wherein the housing (204) comprises a rear wall having a surface (302); and
cutting at least one flow channel (214A, 214B, 306A, 306B, 308A, 308B, 312A, 312B) into at least one portion of the surface (302) of the rear wall.

2. The method of claim 1, further comprising, prior to cutting the at least one flow channel (214A, 214B, 306A, 306B, 308A, 308B, 312A, 312B), affixing a mounting tape (304) to the surface (302) of the rear wall.

3. The method of claim 1 or claim 2, wherein cutting the at least one flow channel (214A, 214B, 306A, 306B, 308A, 308B, 312A, 312B) comprises cutting a first flow channel in a portion of the rear wall adjacent to a first side of the mounting tape (304).

4. The method of any preceding claim, wherein cutting the at least one flow channel (214A, 214B, 306A, 306B, 308A, 308B, 312A, 312B) comprises cutting a second flow channel in a portion of the rear wall adjacent to a second side of the mounting tape (304).

5. The method of any preceding claim, wherein cutting the at least one flow channel (214A, 214B, 306A, 306B, 308A, 308B, 312A, 312B) further comprises:
selecting a flow channel pattern (306A, 306B, 308A, 308B, 312A, 312B); and
utilizing the flow channel pattern (306A, 306B, 308A, 308B, 312A, 312B) to cut the at least one flow channel (214A, 214B) into at least one portion of the rear wall of the LED module (200, 300, 310, 320, 402, 404).

6. The method of any preceding claim, wherein cutting the flow channel (214A, 214B, 306A, 306B, 308A, 308B, 312A, 312B) further comprises cutting a flow channel (214A, 214B, 306A, 306B, 308A, 308B, 312A, 312B) into the rear wall of the LED module (200, 300, 310, 320, 402, 404) to a depth of between 0.1 and 1.0 millimeters (mm).

7. The method of claim 6, wherein the depth of the flow channel (214A, 214B, 306A, 306B, 308A, 308B, 312A, 312B) is 0.4 mm.

8. The method of claim 6, wherein the depth of the flow channel (214A, 214B, 306A, 306B, 308A, 308B, 312A, 312B) is 0.7 mm.

9. An LED module (200, 300, 310, 320, 402, 404) comprising:
at least one light emitting diode (LED) (202A, 202B, 202C, 202D);
at least one wire (208A, 208B, 208C, 208D) operably connected to the LED (202A, 202B, 202C, 202D); and
a housing (204) which accommodates the at least one LED (202A, 202B, 202C, 202D) and the at least one wire (208A, 208B, 208C, 208D), and wherein the housing (204) comprises at least one flow channel (214A, 214B, 306A, 306B, 308A, 308B, 312A, 312B) cut into a rear wall of the housing (204) for accepting glue when bonding the LED module (200, 300, 310, 320, 402, 404) to a substrate.

10. The LED module (200, 300, 310, 320, 402, 404) of claim 9, further comprising a mounting tape (304) affixed to a portion of the rear wall of the LED module (200, 300, 310, 320, 402, 404).

11. The LED module (200, 300, 310, 320, 402, 404) of claim 9 or claim 10, wherein the at least one flow channel (214A, 214B, 306A, 306B, 308A, 308B, 312A, 312B) comprises a first flow channel cut into a portion of the rear wall on a first side adjacent the mounting tape (304).

12. The LED module (200, 300, 310, 320, 402, 404) of claim 10, wherein the at least one flow channel (214A, 214B, 306A, 306B, 308A, 308B, 312A, 312B) comprises a second flow channel cut into a portion of the rear wall on a second side adjacent the mounting tape (304).

13. The LED module (200, 300, 310, 320, 402, 404) of claim 9, wherein the at least one flow channel (214A, 214B, 306A, 306B, 308A, 308B, 312A, 312B) cut into a rear wall of the housing (204) has a depth of between 0.1 and 1.0 millimeters (mm).

14. The LED module (200, 300, 310, 320, 402, 404) of claim 13, wherein the depth of the at least one flow channel (214A, 214B, 306A, 306B, 308A, 308B, 312A, 312B) is 0.4 mm.

15. The LED module (200, 300, 310, 320, 402, 404) of claim 13, wherein the depth of the at least one flow channel (214A, 214B, 306A, 306B, 308A, 308B, 312A, 312B) is 0.7 mm.
